# EUROPEAN PATENT APPLICATION

(11) **EP 4 113 637 A1**
(43) Date of publication of application: **04.01.2023**
(21) Application number: 22182044.2
(22) Date of filing: 29.06.2022
(51) Int. Cl.: H01L 35/16

(54) **A COATED SUBSTRATE**

(30) Priority: 30.06.2021 EP 21182795
(71) Applicant: CRH Nederland B.V., 1083 HL Amsterdam (NL)
(72) Inventor: SANTAMARIA RAZO, Diego A., 1083 HL Amsterdam (NL); GONZÁLEZ CALDERÓN, José Amir, 38010 Celaya (MX)
(74) Representative: Slingsby Partners LLP

(57) **Abstract**

The present invention relates to a coated substrate comprising:
a. a substrate with a first surface; and
b. a coating disposed on the first surface, wherein the coating comprises a polymer and a thermoelectric material, wherein the thermoelectric material comprises a complex sulphide mineral.

## Description

### Background to the invention

Thermoelectric effects are well known. The Seebeck effect is a form of thermoelectric effect which appears when a temperature difference between two different electrical conductors or semiconductors produces a voltage difference between the two substances. When heat is applied to one of the two conductors or semiconductors, the heated electrons tend to flow from the hottest conductor or semiconductor to the coldest. If the pair is connected through an electrical circuit, direct current (DC) flows through that circuit. The voltages produced by the Seebeck effect are small, usually a few microvolts (millionths of a volt) per temperature difference at the junction. If the temperature difference is large enough, some Seebeck devices can produce millivolts (thousandths of a volt).

Thermoelectric materials which show the Seebeck effect, such as tetrahedrite, are known. The conversion efficiency of this type of material is often expressed as the dimensionless figure of merit: ZT, where T is the absolute temperature and Z is related to the material properties as ZT=S² σT/κ, where S is a high thermal power or Seebeck coefficient, σ is electrical conductivity and κ is thermal conductivity. To improve the efficiency of thermoelectric materials, ZT should be maximized. This means that more electric potential is produced for a given temperature difference.

There are increasing demands for electricity, particularly electricity use in buildings. It is desirable for buildings to become more self-sufficient in producing energy, and existing solutions such as utilising solar power and heat pumps are known to provide part of an electricity supply to a building, such as a heating or hot water system.

There is a need to produce electricity in an environmentally friendly way. There is a need for construction to be energy efficient. There is a need for buildings to become more self-sufficient in generating electricity for use. There is a need to utilise construction materials to generate electricity. There is a need to retro-fit a means of producing electricity to existing constructions, such as buildings. There is a need to recycle waste materials from mining.

It is, therefore, an object of the present invention to seek to alleviate the above identified problems.

### Summary of the invention

In a first aspect of the invention, there is provided a coated substrate comprising:
a. a substrate with a first surface; and
b. a coating disposed on the first surface, wherein the coating comprises a polymer and a thermoelectric material, wherein the thermoelectric material comprises a complex sulphide mineral.

In a second aspect of the invention, there is provided a coating comprising a polymer and a thermoelectric material, wherein the thermoelectric material comprises a complex sulphide mineral.

In a third aspect of the invention, there is provided a method of making a coated substrate, comprising:
i. providing a substrate with a first surface;
ii. providing a coating, wherein the coating comprises a polymer and a thermoelectric material, wherein the thermoelectric material comprises a complex sulphide mineral; and
iii. applying the coating to the first surface to form the coated substrate.

In a fourth aspect of the invention, there is provided an electrical circuit comprising the coated substrate as described herein and a pair of conductors.

In a fifth aspect of the invention, there is provided a method of generating a potential difference, comprising providing a coating as described herein, providing a temperature difference between a first side of the coating and a second side of the coating and connecting the coating via a pair of electrical conductors to an electrical circuit.

### Detailed Description

The present invention relates to a coated substrate comprising:
a. a substrate with a first surface; and
b. a coating disposed on the first surface, wherein the coating comprises a polymer and a thermoelectric material, wherein the thermoelectric material comprises a complex sulphide mineral.

It is a particular advantage of the invention, that the coating can be applied to existing substrates, such as a wall, a floor, a post or a building. This allows the coating to be retrofitted, such as to an existing wall, floor, post or building. This helps improve the energy efficiency of an existing construction project. The coating can also be applied in advance, such as in a factory, or onsite during construction. The coating allows electricity to be produced in an environmentally friendly way by utilising the temperature difference across the coating between the substrate and the environment the substrate is in. For example, the temperature of an external wall and the temperature of a room. It is a further advantage that the temperature difference can be utilised when the room temperature is higher or lower than the temperature of the external wall. This means that electricity can be produced throughout the seasons. Further, the present invention can be used to recycle waste materials from mining, such as the complex sulphide mineral. The invention utilises a temperature difference to produce electricity which will reduce the need to obtain electricity from an external source. This improves the energy efficiency of a building and reduces its carbon footprint.

Preferably, the complex sulphide mineral comprises a compound comprising a metal, a semimetal and sulphur, preferably the thermoelectric material comprises a metal antimony sulphide, preferably a copper antimony sulphide. Such materials have a desirable thermoelectric effect.

Preferably, the thermoelectric material comprises tetrahedrite, preferably the thermoelectric material comprises tetrahedrite of the formula *Cu*₁₂₋*ₓMₓZ*₄*S*₁₃₋*_{y}Se_{y},* wherein M is a transition metal, 0 ≤ x ≤ 3, Z is a semimetal and 0 ≤ y ≤ 0.5, preferably Z is Sb, As, Bi, Te or a combination of two or more thereof.

Preferably, Z is Sb, As, Bi or a combination of two or more thereof, preferably Z is Sb, As or a combination thereof, preferably Z is Sb.

Preferably, M is Mn, Ag, Fe, Ni, Co, Zn, Hg or a combination of two or more thereof, preferably Mn, Ag, Fe, Ni, Co or a combination of two or more thereof, preferably Mn, Ag, Fe or a combination of two or more thereof. Preferably, M comprises Zn.

Preferably, y is about 0.

Preferably, the thermoelectric material comprises a compound of the formula *Cu*₁₁*MnSb*₄*S*₁₃.

It is an advantage of the invention that tetrahedrite can be used as the thermoelectric material as this is a byproduct from mining. Further, the data shows the advantages of using this material.

Preferably, the coating comprises about 0.1 wt% to about 3 wt% thermoelectric material, preferably about 0.2 wt% to about 2 wt% thermoelectric material. Such amounts allow electricity to be generated across the coating. Further, such amounts do not substantially change the appearance of the substrate which is desirable for aesthetic reasons.

Preferably, the thermoelectric material is in the form of particles, preferably the particles have a diameter in the range of about 100 nm to about 1 mm, preferably in the range of about 500 nm to about 500 µm, preferably about 1 µm to about 200 µm, preferably about 10 µm to about 100 µm. Particles are a suitable way to distribute the thermoelectric material throughout the coating. The particle sizes are suitable to show a useful thermoelectric effect. Further, such particle sizes do not substantially change the appearance of the substrate which is desirable for aesthetic reasons. Particle size is preferably measured by laser diffraction.

Preferably, the coating further comprises an electrically conductive additive, preferably the electrically conductive additive comprises carbon nanotubes, graphene, petroleum coke, graphite, zinc, iron or a combination of two or more thereof, preferably single walled carbon nanotubes. Such materials enhance the electrical conductivity of the coating to improve the thermoelectric effect.

Preferably, the coating comprises about 1 wt% to about 25 wt% electrically conductive additive, preferably about 10 wt% to about 20 wt%. Such amounts are useful for improving the thermoelectric effect.

Preferably, the coating does not comprise an electrically conductive additive. It is an advantage that the invention does not require an electrically conductive additive.

Preferably, the polymer comprises polyurethane, polyethylene, polypropylene, polystyrene, epoxy resin, polyaniline (PANI), polyalkyl thiophenes, poly(3,4-ethylenedioxythiophene) (PEDOT), polyacetylene, or a combination of two or more thereof, preferably, the polymer comprises polyurethane, polyethylene, polypropylene, polystyrene, epoxy resin, polyacetylene, or a combination of two or more thereof. Such polymers are thermal insulators which enhances the thermoelectrical effect. Such polymers are thermal insulators which enhances the thermoelectrical effect.

Preferably, the polymer comprises a thermosetting resin, preferably polyurethane or epoxy resin. This is for ease of application to the substrate as the polymer, and thus the coating can cure once they have been applied to the substrate. This creates a strong bond between the substrate and the coating.

Preferably, the polymer is an electrically conductive polymer, preferably polyaniline (PANI) or (3,4-ethylenedioxythiophene) (PEDOT). Such polymers help enhance the thermoelectric effect.

Preferably the polymer is not an electrically conductive polymer. It is an advantage that the invention does not require an electrically conductive polymer.

Preferably, the polymer comprises a thermoplastic polymer, preferably polyethylene, polypropylene or polystyrene, preferably polyethylene or polypropylene. These are particularly suitable for including in the coating. It is advantageous that they are thermal insulators as this enhances the thermoelectric effect by helping to maintain the temperature difference across the coating.

Preferably, the coating comprises at least about 25 wt% polymer, preferably about 25 wt% to about 97 wt%, preferably about 30 wt% to about 90 wt%, preferably about 50 wt% to about 80 wt%. Such amounts are suitable for applying and adhering the coating to the first surface of the substrate.

Preferably, the coating is substantially homogeneous. This allows the thermoelectric effect to be substantially consistent throughout the coating for a given temperature difference.

Preferably, the coating has a thickness in the range of about 10 µm to about 500 µm, preferably in the range of about 20 µm to about 200 µm, preferably in the range of about 50 µm to about 100 µm. Such thicknesses allow the thermoelectric effect to be produced in useful levels. Further, such amounts do not substantially change the appearance of the substrate which is desirable for aesthetic reasons.

Preferably, the coating is disposed on a portion of the first surface, preferably on about two or more portions of the first surface, preferably on about three or more portions of the first surface, preferably on about 2 to about 1000 portions of the first surface, preferably about 5 to about 500 portions of the first surface, preferably on about 50 to about 200 portions of the first surface. Preferably, where the coating is disposed on more than one portion of the first surface, the portions are separated by an area which does not comprise the coating. Preferably the portions are discrete. Preferably the first surface comprises an array of portions with the coating disposed on, preferably the portions are separated by an area that does not comprise the coating. Preferably, the area that does not comprise the coating prevents contact between adjacent portions. Preferably, the portions are at least about 0.5 mm apart, preferably about 0.5 mm to about 5 cm apart, preferably about 1 mm to about 1 cm apart. This improves the efficiency of the thermoelectric coating. Preferably, each portion has a surface area of about 1 cm² to about 50 cm², preferably about 2 cm² to about 40 cm², preferably about 5 cm² to about 30 cm², preferably about 10 cm² to about 25 cm². It is advantageous to use the coating on portions of the surface to maximise the thermoelectric effect.

Preferably, each portion of the first surface has the shape of a rectangle, square, circle, oval, triangle or polygon. This allows efficient application of the coating and accurate measurement of the surface are of the coating.

Preferably, each portion may be irregular. This allows the coating to be easily applied to an existing first surface.

Preferably, the coating is disposed on at least about 20% of the surface area of the first surface, preferably the coating is disposed on about 20% to about 100% of the surface area of the first surface, preferably about 30% to about 95%, preferably about 40% to about 90%. It is an advantage of the invention that there is the flexibility to cover different amounts of the first surface with the coating.

Preferably, the substrate comprises a wall, a floor, a post or a building. These are suitable substrates which will have a temperature difference to allow the thermoelectric effect to occur.

Preferably, the substrate comprises concrete, plaster, brick, glass, wood, plastic or a combination of two or more thereof, preferably concrete, plaster, brick, wood, plastic or a combination of two or more thereof. These are suitable materials to provide the coating on.

Preferably, the first surface has a surface area of at least about 1 cm², preferably at least about 10 cm², preferably at least about 100 cm². Preferably, the first surface has a surface area in a range of about 1 cm² to about 1 km², preferably in a range of about 100 cm² to about 100 m², preferably in a range of about 1 m² to about 10 m².

Preferably, the first surface is substantially planar.

Preferably, the substrate is substantially cuboidal.

Preferably, the substrate is monolithic.

Preferably, the coating may be applied to more than one first surface. In this way, the amount of electricity produced can be increased by utilising more surfaces, such as more surfaces of a building.

Another aspect of the present invention relates to an electrical circuit comprising the coated substrate as described herein and a pair of conductors. This allows the electricity generated to be used. Preferably, each portion of the first surface comprises a pair of electrical conductors, preferably, two or more pairs of electrical conductors are connected together, preferably substantially all of the pairs of electrical conductors are connected together. Preferably, the pairs of electrical conductors are connected in groups. This allows efficient use of the potential difference produced. Preferably, the electrical conductors described herein comprise a metal, preferably copper or aluminium, preferably copper.

Another aspect of the present invention relates to a method of generating a potential difference, comprising providing a coating as described herein, providing a temperature difference between a first side of the coating and a second side of the coating and connecting the coating via a pair of electrical conductors to an electrical circuit.

Another aspect of the present invention relates to a coating comprising a polymer and a thermoelectric material, wherein the thermoelectric material comprises a complex sulphide mineral. The coating can be applied to a substrate as described herein. The coating is further described herein.

Another aspect of the present invention relates to a method of making a coated substrate, comprising:
i. providing a substrate with a first surface;
ii. providing a coating, wherein the coating comprises a polymer and a thermoelectric material, wherein the thermoelectric material comprises a complex sulphide mineral; and
iii. applying the coating to the first surface to form the coated substrate.

Preferably, step (iii) comprises applying the coating to a portion of the first surface, wherein the method preferably comprises the features of the portion(s) as described herein.

Preferably, the step (iii) further comprises drying the coating to form the coated substrate.

The method preferably comprises the features of the coating and substrate described herein.

Preferably, the coating is provided as an emulsion, a suspension, a solution or a melt. These are suitable forms for the coating. It will be appreciated that the form will be selected for the polymer. Preferably, wherein the polymer comprises a polymeric material, the coating is provided as an emulsion or in a melt. Preferably, wherein the polymer comprises polyurethane, the coating is provided as an emulsion, a suspension or a solution. Preferably, wherein the polymer is an epoxy resin, the coating is provided as a solution.

Preferably, in step (iii), the coating is applied using a brush, roller, stamp, sprayer or a combination of two or more thereof. These methods are useful for providing a coating.

### Examples

### Example 1

Test samples were produced to show the thermoelectric effect generated using different polymers and tetrahedrite with different particle sizes.

Test samples were made with a thickness of 5 mm, a width of 1 cm and a length of 5 cm.

Samples containing polyethylene and polypropylene were made as set out below. The tetrahedrite particles were incorporated into the polymer by extrusion in a twin-screw extruder with three heating zones. The mixture was pelletized and then hot pressed and cut to size to form the film samples.

Samples containing epoxy resin and polyurethane were made as set out below. The respective mixture of materials was prepared by adding the precursor reagents as well as the tetrahedrite particles and mixing these for 5 minutes at 200 rpm with a mechanical head stirrer. The mixture was put onto plates for curing and allowed to stand for one day. The cured mixture was then cut to size to form the film samples.

The conductivity test was carried out by placing the samples longitudinally making contact in a 1 cm square section with the plates at the ends, leaving a 3 cm long section free between both plates. The dishes were designed to have a temperature gradient of 80 °C between both ends, placing thermocouples at the ends to monitor and control the temperature. In the upper area of the composite materials, the positive and negative sensors of a digital multimeter were fixed with thermal paste to evaluate their thermoelectric response. The conductivity results obtained from this test are shown in Table 1. As shown in Table 1, the tetrahedrite dosage in each sample was 0.5 % w/w, 1 % w/w or 2% w/w. No thermoelectric effect was shown in samples that did not include tetrahedrite.

**Table 1**

| | | **Conductivity ×10^-2 ( S/cm)** | | |
|---|---|---|---|---|
| | | **Tetrahedrite Dosage (% w/w)** | | |
| **Polymer** | **Particle size of tetrahedrite (µm)** | **0.5** | **1** | **2** |
| Polypropylene | 10 | 3.1 | 5.2 | 3.8 |
| Polypropylene | 50 | 4 | 4.5 | 3.6 |
| Polypropylene | 90 | 2.3 | 1.8 | 1.7 |
| Polyethylene | 10 | 6.5 | 7.3 | 7.1 |
| Polyethylene | 50 | 7.8 | 7.6 | 6.6 |
| Polyethylene | 90 | 5.8 | 6.1 | 5.7 |
| Polyurethane | 10 | 3.8 | 3.6 | 3.6 |
| Polyurethane | 50 | 3.2 | 3.2 | 3.3 |
| Polyurethane | 90 | 2.5 | 2.1 | 1.8 |
| Epoxy resin | 10 | 0.6 | 0.9 | 1.1 |
| Epoxy resin | 50 | 0.5 | 0.8 | 0.8 |
| Epoxy resin | 90 | 0.3 | 0.3 | 0.3 |

The results show that the samples give thermoelectric effect and can thus be used as a coating as set out in the invention.

Within this specification embodiments have been described in a way which enables a clear and concise specification to be written, but it is intended and will be appreciated that embodiments may be variously combined or separated without parting from the invention. For example, it will be appreciated that all preferred features described herein are applicable to all aspects of the invention described herein and vice versa. For example, all preferred features of the coating and/or substrate apply to all aspects of the invention.

Within this specification, the term "about" means plus or minus 20%, more preferably plus or minus 10%, even more preferably plus or minus 5%, most preferably plus or minus 2%.

Within this specification, the term "substantially" means a deviation of plus or minus 20%, more preferably plus or minus 10%, even more preferably plus or minus 5%, most preferably plus or minus 2%.

Within this specification, reference to "substantially" includes reference to "completely" and/or "exactly". That is, where the word substantially is included, it will be appreciated that this also includes reference to the particular sentence without the word substantially.

It should be understood that various changes and modifications to the presently preferred embodiments described herein will be apparent to those skilled in the art. Such changes and modifications can be made without departing from the spirit and scope of the present invention and without diminishing its attendant advantages. It is therefore intended that such changes and modifications are covered by the appended claims.

## Claims

1. A coated substrate comprising:
i) a substrate with a first surface; and
ii) a coating disposed on the first surface, wherein the coating comprises a polymer and a thermoelectric material, wherein the thermoelectric material comprises a complex sulphide mineral.

2. A coated substrate according to claim 1, wherein the complex sulphide mineral comprises a compound comprising a metal, a semimetal and sulphur, preferably wherein the thermoelectric material comprises a metal antimony sulphide, preferably a copper antimony sulphide.

3. A coated substrate according to any preceding claim, wherein the thermoelectric material comprises tetrahedrite, preferably wherein the thermoelectric material comprises tetrahedrite of the formula *Cu*₁₂₋*ₓMₓZ*₄*S*₁₃₋*_{y}Se_{y},* wherein M is a transition metal, 0 ≤ x ≤ 3, Z is a semimetal and 0 ≤ y ≤ 0.5, preferably wherein Z is Sb, As, Bi, Te or a combination of two or more thereof, preferably wherein Z is Sb, As, Bi or a combination of two or more thereof, preferably wherein Z is Sb, As or a combination thereof, preferably wherein Z is Sb; and/or
wherein M is Mn, Ag, Fe, Ni, Co, Zn, Hg or a combination of two or more thereof, preferably Mn, Ag, Fe, Ni, Co or a combination of two or more thereof, preferably Mn, Ag, Fe or a combination of two or more thereof; and/or
wherein y is about 0; and/or
wherein the thermoelectric material comprises a compound of the formula *Cu*₁₁*MnSb*₄*S*₁₃.

4. A coated substrate according to any preceding claim, wherein the coating comprises about 0.1 wt% to about 3 wt% thermoelectric material, preferably about 0.2 wt% to about 2 wt% thermoelectric material.

5. A coated substrate according to any preceding claim, wherein the thermoelectric material is in the form of particles, preferably wherein the particles have a diameter in the range of about 100 nm to about 1 mm, preferably in the range of about 500 nm to about 500 µm, preferably about 1 µm to about 200 µm, preferably about 10 µm to about 100 µm.

6. A coated substrate according to any preceding claim, wherein the coating further comprises an electrically conductive additive, preferably:
i) wherein the electrically conductive additive comprises carbon nanotubes, graphene, petroleum coke, graphite, zinc, iron or a combination of two or more thereof, preferably single walled carbon nanotubes; and/or
ii) wherein the coating comprises about 1 wt% to about 25 wt% electrically conductive additive, preferably about 10 wt% to about 20 wt%.

7. A coated substrate according to any preceding claim, wherein the polymer comprises polyurethane, polyethylene, polypropylene, polystyrene, epoxy resin, polyaniline (PANI), polyalkyl thiophenes, poly(3,4-ethylenedioxythiophene) (PEDOT), polyacetylene, or a combination of two or more thereof, preferably polyurethane, polyethylene, polypropylene, polystyrene, epoxy resin, polyacetylene, or a combination of two or more thereof.

8. A coated substrate according to any preceding claim, wherein the coating is substantially homogeneous; and/or
wherein the coating has a thickness in the range of about 10 µm to about 500 µm, preferably in the range of about 20 µm to about 200 µm, preferably in the range of about 50 µm to about 100 µm.

9. A coated substrate according to any preceding claim, wherein the coating is disposed on a portion of the first surface, preferably on about two or more portions of the first surface, preferably on about three or more portions of the first surface, preferably on about 2 to about 1000 portions of the first surface, preferably about 5 to about 500 portions of the first surface, preferably on about 50 to about 200 portions of the first surface; and/or
wherein the coating is disposed on at least about 20% of the surface area of the first surface, preferably the coating is disposed on about 20% to about 100% of the surface area of the first surface, preferably about 30% to about 95%, preferably about 40% to about 90%; and/or
wherein each portion has a surface area of about 1 cm² to about 50 cm², preferably about 2 cm² to about 40 cm², preferably about 5 cm² to about 30 cm², preferably about 10 cm² to about 25 cm².

10. A coated substrate according to any preceding claim, wherein the substrate comprises a wall, a floor, a post or a building; and/or
wherein the substrate comprises concrete, plaster, brick, glass, wood, plastic or a combination of two or more thereof, preferably concrete, plaster, brick, wood, plastic or a combination of two or more thereof.

11. An electrical circuit comprising the coated substrate according to any preceding claim and a pair of electrical conductors.

12. A coating comprising a polymer and a thermoelectric material, wherein the thermoelectric material comprises a complex sulphide mineral.

13. A method of making a coated substrate, comprising:
i) providing a substrate with a first surface;
ii) providing a coating, wherein the coating comprises a polymer and a thermoelectric material, wherein the thermoelectric material comprises a complex sulphide mineral; and
iii) applying the coating to the first surface to form the coated substrate.

14. A method according to claim 13, wherein the coating is provided as an emulsion, a suspension, a solution or a melt.

15. A method according to claim 13 or claim 14, or a coating according to claim 12, further comprising the features of any of claims 1 to 10.
